(19) **Europäisches Patentamt / European Patent Office / Office européen des brevets**

(11) **EP 1 547 152 B1**

(12) **EUROPEAN PATENT SPECIFICATION**

(45) Date of publication and mention
of the grant of the patent:
**08.04.2009 Bulletin 2009/15**

(51) Int Cl.:
***H01L 27/146*** (2006.01)

(21) Application number: **03754405.3**

(22) Date of filing: **22.08.2003**

(86) International application number:
**PCT/US2003/026253**

(87) International publication number:
**WO 2004/019609 (04.03.2004 Gazette 2004/10)**

(54) **A CMOS APS WITH STACKED AVALANCHE MULTIPLICATION LAYER AND LOW VOLTAGE READOUT ELECTRONICS**

CMOS APS MIT GESTAPELTER LAWINENVERMEHRUNGSSCHICHT UND
NIEDERSPANNUNGSAUSLESESCHALTUNG

APS A CMOS POURVU D'UNE COUCHE DE MULTIPLICATION EN AVALANCHE EMPILEE ET
DISPOSITIF ELECTRONIQUE DE LECTURE DE BASSE TENSION

(84) Designated Contracting States:
**AT BE BG CH CY CZ DE DK EE ES FI FR GB GR HU IE IT LI LU MC NL PT RO SE SI SK TR**

(30) Priority: **23.08.2002 US 226190**
**23.08.2002 US 226326**

(43) Date of publication of application:
**29.06.2005 Bulletin 2005/26**

(73) Proprietor: **Micron Technology, Inc.**
**Boise, ID 83707-0006 (US)**

(72) Inventors:
• **TAKAYANAGI, Isao**
**Tokyo 194-0211 (JP)**
• **MAKAMURA, Junichi**
**Tokyo 195-0055 (JP)**

(74) Representative: **Collins, John David**
**Marks & Clerk**
**90 Long Acre**
**London**
**WC2E 9RA (GB)**

(56) References cited:
**EP-A- 1 187 217      US-A- 4 973 833**
**US-A- 5 371 392      US-A- 5 818 052**

• YAMAUCHI M ET AL: "CMOS image sensor overlaid with a HARP photo-conversion film" CONFERENCE PROCEEDINGS ON OPTOELECTRONIC AND MICROELECTRONIC MATERIALS AND DEVICES, 6 December 2000 (2000-12-06), pages 89-92, XP010596217 Bandoora, Australia cited in the application

## Description

FIELD OF THE INVENTION

The present invention relates to image sensors which use a stacked avalanche multiplication layer to amplify the intensity of light captured by a pixel circuit.

BACKGROUND OF THE INVENTION

Amid the rising popularity for digital image devices such as digital cameras is a demand for increasingly higher picture resolution and for increasingly compact designs of such devices. Due to the interior space constraints in the housings of the compact designs, it is necessary to reduce the sizes of the electronic circuits in the device, including the image sensor. However, upon shrinking the size of the image sensor, a tradeoff must be made between resolution and the signal levels outputted from the image sensor. If the resolution is kept the same upon reducing the size of the image sensor, the size of each pixel must be proportionately reduced. Smaller pixels reduce the amount of charge that can be collected by each pixel during image exposure, which in turn reduces the sensitivity of the image sensor. Although the reduced sensitivity effect can be offset by increasing the integration (exposure) time, this is an undesirable "solution" because increasing integration time also increases the potential for obtaining a blurred image if there is any movement by the image subject or the device during exposure. On the other hand, in order to maintain the same sensitivity without having to increase integration time, the pixels must be made larger, which limits the resolution.

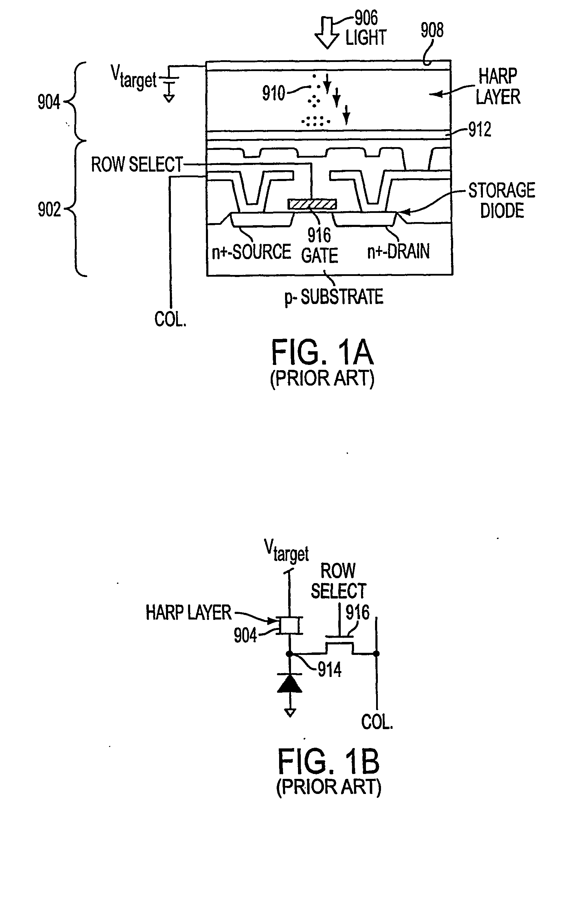

One solution towards achieving both a more compact size and high image quality is disclosed in "CMOS Image Sensor Overlaid with a HARP Photoconversion Layer," by T. Watabe, et al., published in the Program of the 1999 IEEE Workshop on Charge-Coupled Devices and Advanced Image Sensors, pp. 211-214. In this image sensor, which is shown in FIGS. 1A and 1B, the pixel circuit 902 is overlaid with a stacked charge multiplying photoconversion layer, such as a high-gain avalanche rushing amorphous photoconductor ("HARP") photo-conversion layer 904 for amplifying the light signal produced by each pixel.

When a photon 906 hits the upper surface 908 of the HARP layer 904, a charge 910 in the form of holes is generated and amplified to many times its original level while being propelled through the HARP layer 904 to the bottom side 912. The pixel circuit 902 is electrically connected to the bottom side 912 of the HARP layer 904 such that the amplified light signal 910, upon reaching the bottom side 912 of HARP layer 904, is conducted into the pixel circuit 902 as electrical charge. The charge accumulates at a storage node 914 in the pixel circuit until the pixel data is read out by activating the gate of a row select switch 916. The amount of charge accumulated at the node 914, which is proportional to the intensity of light 906 detected, is read out. In this manner, the image sensor of FIGS. 1A and 1B allows each pixel to capture image data with an intensity and sensitivity equivalent to that attainable by significantly larger pixels which do not have the avalanche multiplication capability. As a result, use of a HARP layer enables the image quality to be improved without having to increase the size of the image sensor array.

In order to obtain avalanche multiplication in the HARP layer, an electric field of about $10^6$ V/cm is required, which is achieved by applying an operating voltage of between 50 -100 V to the HARP layer. In a typical HARP image sensor, voltages of less than about 8 V are used in the pixel circuit connected beneath the HARP layer, with the pixel circuit generally having a breakdown voltage of around 20 V. When the intensity of the incident light on the image sensor is at the upper end of the detection range for the charge multiplying photoconversion layer, the voltage level accumulating at the storage diode beneath the HARP layer approaches the level of the operating voltage applied to the HARP layer. Thus, voltages of 50-100 V may be applied to the storage diode when the image sensor is exposed to a strong light, resulting in a breakdown of the readout components of the pixel circuit.

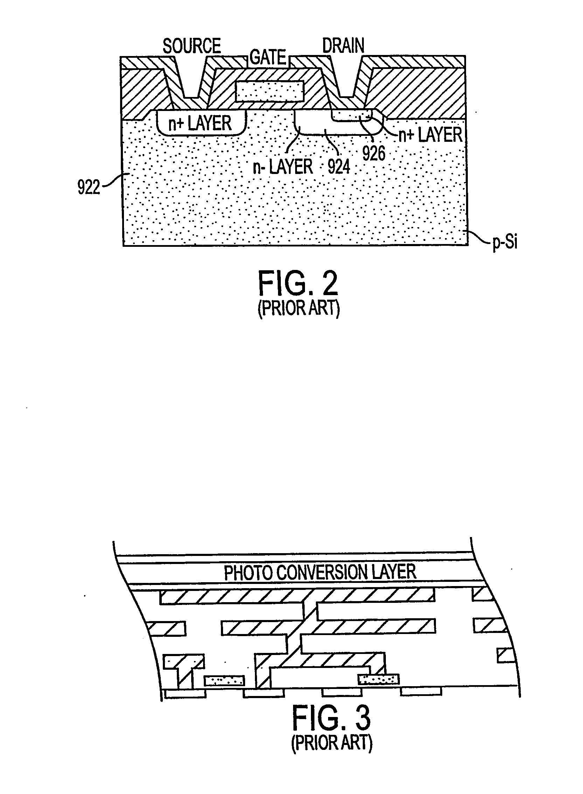

To address this problem, attempts have been made to build a pixel circuit having a higher breakdown tolerance. An example of such a high tolerance pixel circuit is disclosed in the article by T. Watabe *et al.* mentioned above, in which the pixel circuit is constructed as MOS transistor having a double drain structure. This structure is shown in FIG. 2, in which the n-doped drain formed in the p-doped silicon layer 922 includes a low-dose n- region 924 surrounding a conventional high-dose n+ region 926. The double drain MOS transistor structure was shown to achieve an endurance voltage up to just under 60 V. However, a special MOS fabrication process is required for forming the double drain MOS transistor, and the size of the MOS transistor makes it difficult to attain small pixel sizes for high resolution image sensors.

Another problem encountered in typical HARP image sensors when the voltage level at the storage node rises is that the effective voltage applied across the photoconversion layer decreases, which affects the charge amplification function of the photoconversion layer. For example, in the arrangement shown in FIGS. 1A and 1B, as the charge representing a detected light flows from the HARP layer 904 and accumulates on the node 914 of the storage diode, the voltage at the node 914 increases, causing the potential difference between the operating voltage $V_{target}$ applied to the HARP layer 904 and the storage node 914 to decrease. The result is pixel signal saturation and a nonlinear response in which the signal levels recorded by the imaging device are not correctly represented in the pixel output.

To address this problem, it is necessary to find a way to amplify the intensity of light signals by the same amount under bright light conditions as for lower light conditions, by either accounting for the loss of effective operating voltage across the charge multiplying photoconversion layer or otherwise addressing the decreasing amplification in bright light conditions.

US 5818052 discloses a low light level solid state image sensor. The high sensitivity at low light level is achieved by an image sensor combination of a photoconductor with high avalanche detection gain, a silicon detector with very high gain pixel level amplifiers and noise suppression circuits. A high gain avalanche rushing photoconductor (HARP) sensor device is connected to an amplified metal oxide silicon (AMOS) device and a low noise readout device. The high sensitivity image sensor is fabricated by depositing an amorphous Selenium photoconductive layer on the top of a silicon junction diode or a Palladium Silicide, (Pd2Si) Schottky barrier diode that is connected to the AMOS pixel amplifier circuits to form a two story circuit.

In "CMOS image sensor overlaid with a HARP photoconversion film", published in Conference Proceedings on Optoelectronic and Microelectronic Materials and Devices, 6 December 2000, pages 89-92, Bandoora, Australia, Yamauchi *et al* disclosed new CMOS image sensor that was made by overlaying a HARP (high-gain avalanche rushing amorphous photoconductor) photo-conversion film on to the CMOS readout circuit. Prototype sensors were fabricated that used a new MOS transistor to increase breakdown voltage in the readout circuit. Connecting processes were developed and used to connect the HARP film to the readout circuit. Stable operation of the sensor was observed when the target voltage of 60 volts was applied.

US 5371392 discloses a semiconductor apparatus and horizontal register for solid state image pickup apparatus with a protection circuit. A semiconductor apparatus connected between a signal input line and a grounding line is formed on a semiconductor substrate with a protection circuit connected between the signal input line and the grounding line, in parallel with the semiconductor apparatus. The protection circuit is formed, for example, of bipolar transistors, diodes, or MOS transistors.

EP 1187217 discloses a solid state image-sensing device having a photosensitive element that produces an electric signal commensurate with the amount of light incident thereon, a transistor of which the first electrode and the control electrode are connected to one electrode of the photosensitive element, and a resetting portion for resetting the transistor by feeding a predetermined pulse signal to the second electrode of the transistor The resetting portion resets the transistor in such a way as to inhibit the transistor from operating in a subthreshold region when the amount of light incident on the photosensitive element is below a predetermined level.

BRIEF SUMMARY OF THE INVENTION

A first aspect of the present invention serves to mitigate problems associated with the high voltages which may be generated by a HARP layer under bright light conditions by incorporating a protection circuit into the pixel circuit connected to the HARP layer. The protection circuits prevents the pixel circuit from breaking down when the voltage in the pixel circuit reaches the operating voltage applied to the charge multiplying photoconversion layer in response to the image sensor being exposed to a strong light, by limiting a voltage which accumulates at the charge storage element to a reference potential. In particular, the protection circuit of the present invention may be designed in any of several configurations is which additional voltage entering the pixel circuit from the charge multiplying photoconversion layer over a predetermined threshold voltage level is dissipated before reaching the storage node and other lower voltage components downstream therefrom.

A second aspect of the present invention addresses the problem of pixel saturation and nonlinear amplification of the image signal output from a charge multiplying photoconversion layer by incorporating an output control circuit into the pixel circuit connected to the charge multiplying photoconversion layer. Preferably, the output control circuit is constructed as a charge trans-impedance amplifier (CTIA) circuit including at least an operational amplifier, wherein the CTIA serves to fix the voltage level at the storage node two thereby maintain a constant effective operating potential across the charge multiplying photoconversion layer.

In one exemplary embodiment of the output control circuit in accordance with the invention, the effective voltage is maintained across a photo-conversion element at a , constant level to provide a linear output throughout the entire operating range of the photoconversion element. Another exemplary embodiment of an output control circuit in accordance with the invention also fixes the voltage across the photoconversion element, and further logarithmically compresses the image signal obtained from the photoconversion element. A third exemplary embodiment of the output control circuit provides a linear output signal in low light conditions until the current from the photoconversion element reaches a predetermined threshold value, whereupon the output control circuit then switches the output to a logarithmic signal in brighter light conditions. Optionally, the output control circuit of this last embodiment may be constructed so that the threshold value between the linear and logarithmic output characteristics is adjustable.

These and other features and advantages of embodiments of the present invention will become more apparent from the following detailed description which is provided with reference to the accompanying drawings.

BRIEF DESCRIPTION OF THE DRAWINGS

FIG. 1A is a cross-sectional view of a pixel in an image sensor having a charge multiplying photoconversion layer as known in the art;
FIG. 1B is a circuit diagram of the pixel arrangement shown in FIG. 1A;
FIG. 2 is a cross-sectional view of a double-drain MOS transistor as known in the art;
FIG. 3 is an illustration of an alternative photoconversion element usable with the present invention;
FIG. 4 is a circuit diagram of a first preferred embodiment in accordance with the present invention;
FIG. 5 is a circuit diagram of a second preferred embodiment in accordance with the present invention;
FIG. 6 is a circuit diagram of a third preferred embodiment in accordance with the present invention;
FIG. 7 is a circuit diagram of a fourth preferred embodiment in accordance with the present invention;
FIG. 8 is a circuit diagram of a fifth embodiment in accordance with the present invention;
FIG. 9 is a circuit diagram of a sixth embodiment in accordance with the present invention;
FIG. 10 is a circuit diagram of a seventh embodiment in accordance with the present invention;
FIG. 11 is a graph for illustrating the conversion characteristics obtained by the embodiment shown in FIG. 10;
FIG. 12 is a circuit diagram of a eighth embodiment in accordance.with the present invention;
FIG. 13 is a circuit diagram in accordance with a ninth embodiment of the present invention;
FIG. 14 is an example of an imaging apparatus incorporating the present invention; and
FIG. 15 is an illustration of a processing system communicating with the imaging apparatus of the present invention.

DETAILED DESCRIPTION OF THE INVENTION

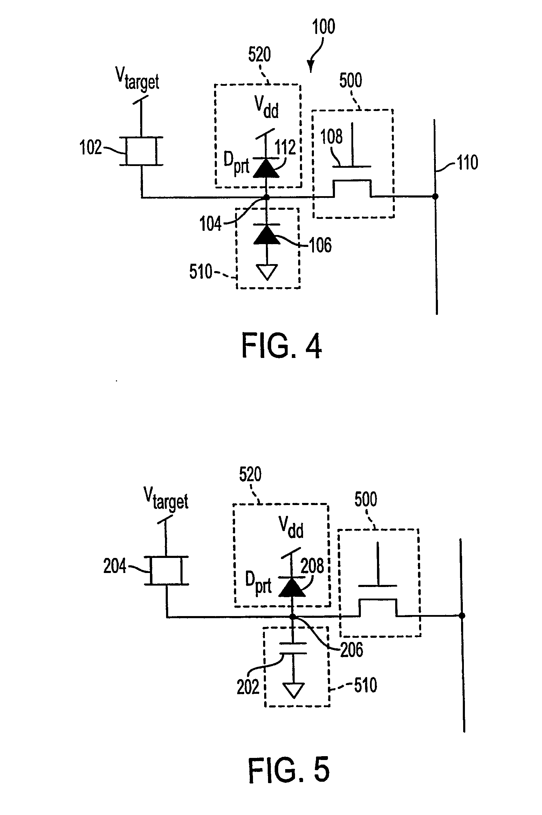

A first aspect of the present invention protects a pixel circuit connected to the HARP layer from breakdown caused by a high voltage transferred to the pixel circuit from the HARP layer under bright light conditions. The pixel circuit is protected from breakdown by incorporating therein a protection circuit which prevents excess voltage above a predetermined threshold level from reaching the components of the pixel circuit downstream from the protection circuit. A pixel structure in accordance with this aspect of the invention is described below with reference to FIGS. 4-7 showing four exemplary embodiments of a protection circuit providing the capability described above.

A first exemplary embodiment of the invention is shown in FIG. 4, and is similar to the pixel arrangement shown in FIG. 1B in that it includes a charge (hole) multiplying photoconversion layer 102 connected to a voltage $V_{target}$ at its upper plate and connected to storage node 104 of a storage element 510 at its bottom plate. In this embodiment, storage element 510 is provided as a storage diode 106. Although the charge multiplying photoconversion layer is preferably a high-gain avalanche rushing amorphous photoconductor (HARP) photoconversion layer, other structures for detecting and performing photoconversion of a light signal and subsequently or simultaneously amplifying the resulting electrical charge may be used. Storage node 104 is the cathode of storage diode 106 for accumulating charge corresponding to image data being collected during the image sensor integration time. An output circuit 500 is connected to and positioned downstream from node 104, for reading out the charge accumulated at storage diode 106. As shown in FIG. 4, output circuit 500 may be simply constructed as a row select transistor 108.

The anode of storage diode 106 is connected to ground so as to block current flow through diode 106 when the voltage at node 104 is a higher level than the ground connection, which will always be the case when an image signal is received from the charge multiplying photoconversion layer 102, since the signal charges are holes. Thus, with respect to storage diode 106, therefore, as long as the row select transistor 108 is open, charge flowing from charge multiplying photoconversion layer 102 as a result of the detection of light will accumulate at node 104.

Row select transistor 108 of output circuit 500 is connected to a column readout line 110 so that when the gate for the row select transistor 108 is closed, the charge at storage node 104 is transferred to the column readout line 110. When the column line containing the relevant pixel is activated, the image data from the pixel is transferred out of the pixel circuit 100 into an image processor where that charge is translated into image data along with the data read out from the other pixels in the image sensor array, to thereby construct the output image.

In order to prevent the charge accumulating at node 104 from reaching the breakdown point of storage diode 106 or row select transistor 108, a protection circuit 520 comprising a protection diode 112, the anode of which is connected to node 104 of storage diode 106. The cathode of protection diode 112 is connected to a voltage $V_{dd}$, so that when the voltage level at storage node 104 reaches the level of $V_{dd}$, any additional voltage arriving from the charge multiplying photoconversion layer 102 is bled off away from node 104 toward the voltage source $V_{dd}$. In this manner, protection diode 112 serves to limit the voltage at node 104 to $V_{dd}$.

Once voltage is bled off from node 104 through protection diode 112, image data representing light intensities detected at the upper end of the capability range of charge multiplying photoconversion layer 102 will be lost. Thus, the voltage level at source $V_{dd}$ should be set to strike a balance between minimizing the potential to lose image data acquired in the upper end of the detection range of layer 102, and limiting the voltage at node 104 to a comfortable level to avoid the risk of breakdown of the storage diode 106 and the row select transistor 108.

A second exemplary embodiment of the invention is shown in FIG. 5, and is identical to the pixel circuit of the first embodiment except that the storage element 510 is embodied as a storage capacitor 202 instead of a storage diode. Preferably, storage capacitor 202 has a large capacitance value per unit area, even more preferably in the rage of 2-5 $fF/\mu^2c$. Such a capacitor provides a higher capacitance value while reducing the space required for the charge storage region, relative to the use of a storage diode.

In this embodiment, charge from the charge multiplying photoconversion layer 204 is stored in the capacitor 202, until the voltage at the capacitor 206 reaches $V_{dd}$. Additional voltage flowing to node 206 from the charge multiplying photoconversion layer 204 is then directed through the protection diode 208 of protection circuit 520 so that the charge stored in the capacitor 202 maintains a voltage of around $V_{dd}$.

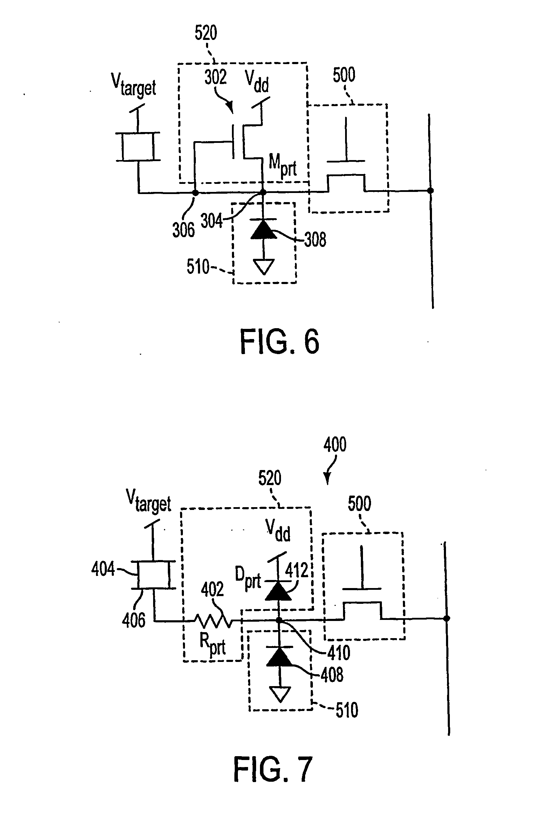

A third exemplary embodiment of the invention, as shown in FIG. 6, is identical to the pixel circuit of the first embodiment, except that the protection diode of the protection circuit 520 is replaced with an n-MOS transistor 302. Both the drain and the gate of the transistor 302 are connected to the storage diode 308 of storage element 510, and the source of the transistor 302 is connected to a voltage potential of $V_{dd}$.

As in the embodiments described previously, charge from the image signal accumulates at the storage node 304 until the voltage at node 304 reaches and surpasses $V_{dd}$. Once this occurs, the higher voltage at the transistor drain causes the excess voltage to flow through the transistor, so that the voltage at the storage node 304 remains around $V_{dd}$.

In a variant of this embodiment, the storage diode 308 of storage element 510 may be replaced with the high capacity capacitor as described above with reference to the embodiment of FIG. 5.

FIG. 7 shows a fourth exemplary embodiment of the invention, which is identical to the embodiment of FIG. 4 except that the protection circuit 520 further includes a resistor 402 positioned between the bottom plate 406 of the charge multiplying photoconversion layer 404 and the storage diode 408 of storage element 510. The resistor preferably has a high resistance value which reduces the voltage passing through the pixel circuit 400 from the charge multiplying photoconversion layer 404 and the storage diode 408 at node 410.

The presence of protection circuit 510, embodied here as protection diode 412, provides additional protection for the pixel circuit 400, so that in the event the signal voltage flowing from the charge multiplying photoconversion layer 404 is significantly larger than $V_{dd}$ that the voltage at node 410 upon passing through resistor 402 is still too high, the excess voltage will be directed away from the storage diode 408 and the row select transistor 414 through the protection diode 412.

A first variation of the FIG. 7 embodiment may be provided by replacing the storage diode 408 of storage clement 510 with the capacitor discussed above in the embodiment of FIG 4. Similarly, the present invention also encompasses a second variation of this embodiment in which the protection diode 412 is replaced with an n-MOS transistor as described above in the embodiment of FIG 5. In a third variation of the FIG. 7 embodiment, both the storage diode 408 of storage element 510 and the protection diode 412 are replaced with the capacitor of FIG. 5 and the n-MOS transistor of FIG. 6, respectively.

In an image sensor using a charge multiplying photoconversion layer, as the voltage level at the storage node rises, the effective voltage applied to the photoconversion layer decreases, which affects the charge amplification function of the photoconversion layer. For example, if the voltage $V_{target}$ applied to the charge multiplying photoconversion layer is reduced, the amplification achieved by the photoconversion layer is also reduced. Thus, when the signal level is read out upon activating the row select switch, the signal level recorded by the imaging device will be less than the signal level actually detected.

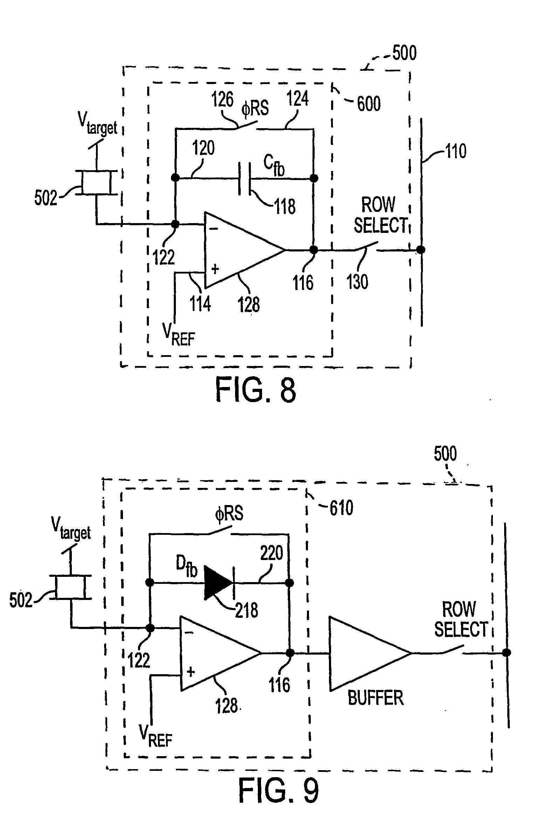

A second aspect of the present invention addresses this concern by incorporating into each pixel circuit an output control circuit which prevents the effective voltage across the photoconversion layer from decreasing during integration of light in the pixel. More specifically, the output control circuits according to this aspect of the invention serve to fix the voltage level at the storage node to maintain a constant effective operating potential across the charge multiplying photoconversion layer. The pixel structure disclosed herein will be further described below with reference to FIGS. 8-13 showing five exemplary embodiments of the output circuit in accordance with this aspect of the invention.

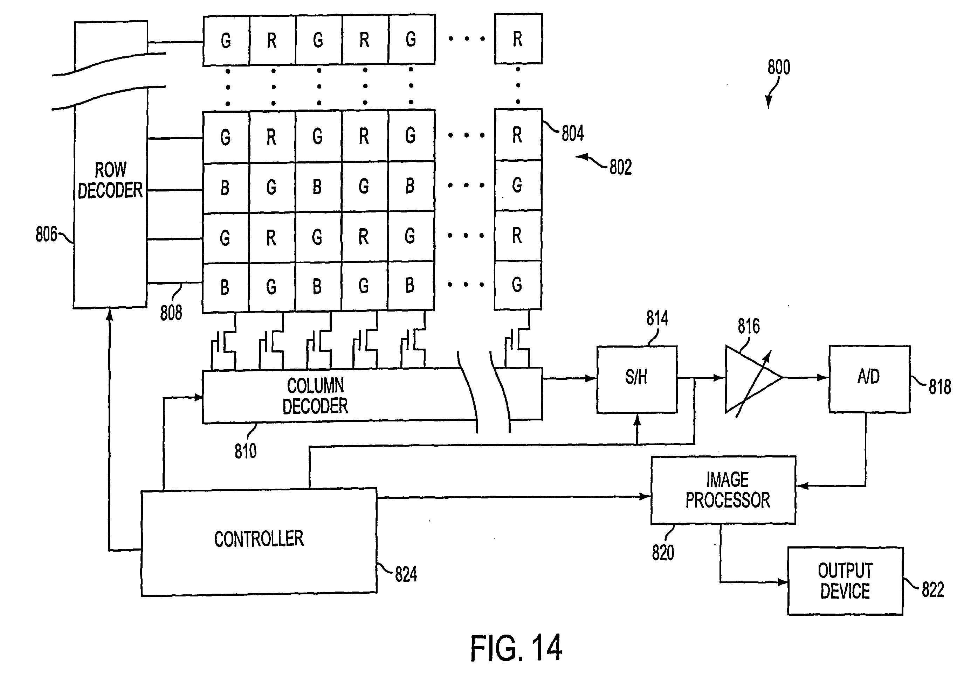

According to a fifth embodiment of the invention, shown in FIG. 8, the pixel structure includes a charge multiplying photoconversion layer 502 connected to a voltage $V_{target}$ at its upper plate. The bottom plate of the charge multiplying photoconversion layer 502 is connected to output circuit 500 which includes a signal generation circuit 600 and a row select switch 130. Signal generation circuit 600 controls the characteristics of the charge received from the charge multiplying photoconversion layer 502. Row select switch 130 is connected to the output side of the signal generation circuit 600 for reading out the accumulated charge representing the image signal acquired from the charge multiplying photoconversion layer 502. Preferably, row select switch 130 is formed as a MOS transistor and operated by a gate signal transmitted by a controller, such as the controller 824 shown in FIG. 14.

Row select switch 130 is connected to column readout line 110 so that when the switch 130 is closed (for example, upon receiving a gate signal from a controller when the row select switch is a transistor), the output voltage of the signal generation circuit 600 is transferred to a column readout line 110 and from there to a sample and hold circuit *(see, e.g.,* element 814 in FIG. 14). The image data from the pixel is transferred from the sample and hold circuit to a digitizer and then to an image processor where that charge is translated into image data along with the data read out from the other pixels in the image sensor array, to thereby construct the output image.

As seen in FIG. 8, the signal generation circuit 600 according to this embodiment is a charge trans-impedance amplifier (CTIA) circuit which includes a differential amplifier 128 connected to a constant voltage supply $V_{REF}$ at a positive input 114 thereof. $V_{REF}$ is set to a value slightly below the operating voltage of the differential amplifier to obtain sufficient output voltage swing. A feedback loop 120 is formed between an output node 116 of the differential amplifier 128 and a negative input node 122 thereof, and a capacitor 118 is connected in the feedback loop 120. A reset switch 126 is connected in a second loop 124 formed between the negative input node 122 and the output node 116 of the differential amplifier 128 and parallel to the feedback loop 120, for shorting out the capacitor 118 at the initialization period preceding each integration time. Row select switch 130 is also connected to the output node 116 of the differential amplifier 128 downstream of the feedback loop 120 and second loop 124.

The differential amplifier 128 forces the voltage at the negative input node 122 to become fixed at $V_{REF}$, which in turn maintains the effective operating potential $V_{target}$ across the charge multiplying photoconversion layer 502 at a constant level, i.e., $V_{target}$- $V_{REF}$. Since the multiplication factor to which an image signal is amplified in the photoconversion layer 502 is a function of the applied bias to the photoconversion layer, fixing the potential at the at the output side of the photoconversion layer 502, which is at the same potential as the negative input node 122 to the differential amplifier 128, yields a constant multiplication factor of the image signals detected by the charge multiplying photoconversion layer 502.

During integration time in this pixel circuit, current from the photoconversion layer 502 is integrated on the capacitor 118. When the row select switch 130 is closed, the output voltage of the differential amplifier 128 is transferred to the column readout line 110. Configured in this manner, the output voltage from the differential amplifier 128 represents the intensity of the detected incident light on the photoconversion layer 502, and is given by Eq. 1 below:

$$V_{out} = V_{REF} - \frac{I_{HARP} \bullet t_{INT}}{C_{fb}} \quad \ldots \ldots \ldots \ldots \ldots \ldots \ldots \quad (1)$$

wherein $I_{HARP}$ and $t_{INT}$ represent the current from the charge multiplying photoconversion layer 502 and the integration time, respectively, and $C_{fb}$ represents the capacitance of the capacitor 118.

With the CTIA as shown in FIG. 8, the signal generation circuit 600 provides a linear output along the entire operating range of charge multiplying photoconversion layer 502.

FIG. 9 shows a pixel circuit in accordance with a second embodiment of the present invention. The pixel circuit of the sixth embodiment is generally the same as the pixel circuit discussed above with reference to FIG. 8, except that the signal generation circuit 600 in FIG. 8 is replaced by signal generation circuit 610 in the embodiment shown in FIG. 9. Components of this embodiment which are equivalent to those shown in FIG. 8 are identified in FIG. 9 with the same reference numerals, and description of those elements will be omitted in the description below.

Like signal generation circuit 600, signal generation circuit 610 also fixes the potential at the output side of a charge multiplying photoconversion layer 502 and the negative input node 122 to a differential amplifier 128, so as to maintain a constant effective input node voltage across the charge multiplying photoconversion layer 502 to be $V_{target}$- $V_{REF}$. Instead of a capacitor connected in the feedback loop, the CTIA circuit of signal generation circuit 610 includes a feedback diode 218 connected in a feedback loop 220 between the output node 116 and the negative input node 122 of the differential amplifier 128. The anode of the feedback diode 218 is connected to the negative input node 122 of the differential amplifier 128 while the cathode of the feedback diode 218 is connected to the output node 116 of the differential amplifier. The current flowing across the feedback diode 218 is determined according to Eq. 2 below:

$$I_{Dfb} = I_o \bullet \left\{ \exp \frac{q}{kT} \left( V_{REF} - V_{out} \right) - 1 \right\} = I_{HARP} \quad \ldots \ldots \ldots \ldots \ldots \quad (2)$$

wherein $I_0$ *is* the saturation current of the feedback diode 218, q represents the charge of an electron (= 1.6 · $10^{-19}$ coulombs (C)), k is Boltzmann's constant (= 1.38 · $10^{-23}$ J/°K), T represents the temperature of the diode measured in degrees Kelvin, $V_{out}$ is the output voltage from the differential amplifier 128, and $I_{HARP}$ represents the current from the charge multiplying photoconversion layer 502.

Using Eq. 2, the output voltage from the differential amplifier 128 can be determined as set forth in Eq. 3:

$$V_{out} = V_{REF} - \frac{kT}{q} \ln \frac{I_{HARP}}{I_0} \quad \ldots \ldots \ldots \ldots \ldots \ldots \quad (3)$$

As can be seen from Eq. 3, the presence of feedback diode 218 in the feedback loop of the signal generation circuit 610 operates to logarithmically compress the current $I_{HARP}$ flowing from the charge multiplying photoconversion layer 502 through the differential amplifier 128. Although the image signal obtained from the pixel circuit shown in FIGS. 1A and 1B becomes compressed due to the decreasing effective voltage across the photoconversion layer as the detected light level increases, logarithmically compressing the image signal with the CTIA of the signal generation circuit 610 enables the pixel readout signal to be correlated much more predictably with the intensity of light actually detected at the photoconversion layer.

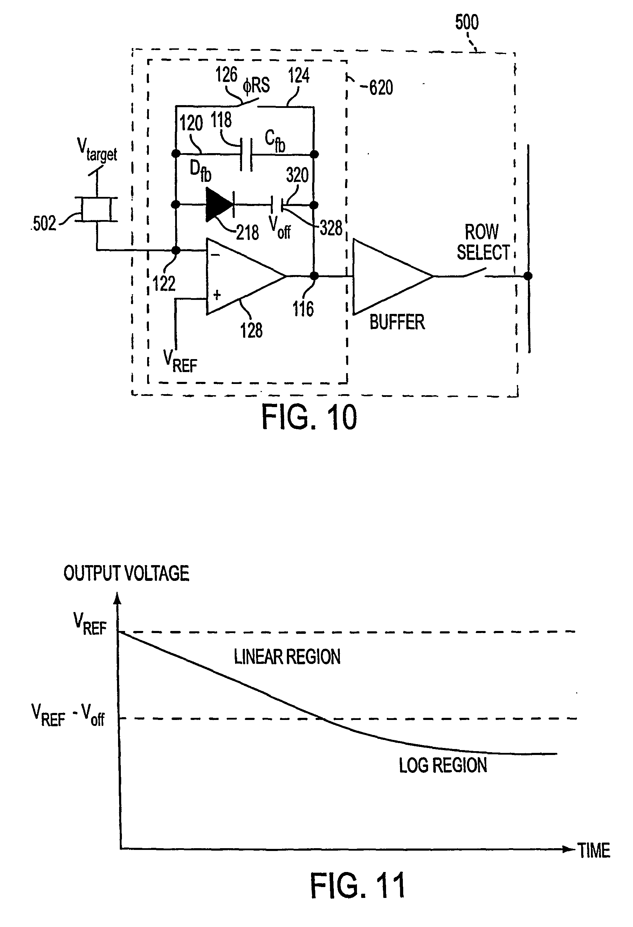

A seventh embodiment of the present invention is shown in FIG. 10 and includes an signal generation circuit 620 in place of the output control circuits 10 and 20 in the fifth and sixth embodiments described above. Components shown in FIG. 10 that are equivalent to the components shown in FIGS. 8 and 9 are identified with the same reference numerals, and discussion of those components will be omitted in the description of this embodiment below. Signal generation circuit 620 is constructed as a CTIA which includes a first feedback loop 120 and a second feedback loop 320 both connected between the output node 116 and the negative input node 122 of a differential amplifier 128.

Feedback loop 120 includes a capacitor 118 for providing a linear output from the differential amplifier 128, similarly to the embodiment of FIG. 8. Feedback loop 320 is arranged in parallel to feedback loop 120 and includes a feedback diode 218 and an offset voltage source 328 that applies a voltage $V_{off}$ to the cathode of feedback diode 218. Offset voltage source 328 is connected to the output node 116 of a differential amplifier 128 and to the cathode of feedback diode 218, while the anode of feedback diode is connected to the negative input node 122 of the differential amplifier 128. A third loop 124 contains a reset switch 126 and is also connected between the output node 116 and the negative input node 122 of differential amplifier 128, in parallel to feedback loops 120 and 320.

The current $I_{HARP}$ from the photoconversion layer 502 flows through the CTIA of signal generation circuit 620 according to Eq. 4 as follows:

$$I_o \cdot \exp \left\{ \frac{q}{kT} \left( V_{REF} - V_{out} - V_{off} \right) \right\} + \frac{d}{dt} C_{fb} \left( V_{REF} - V_{out} \right) = I_{HARP} \quad \ldots \ldots \ldots \quad (4)$$

The first term represents the current flowing across the feedback diode 218 and the second term represents the current flowing to the feedback capacitor 118. When $V_{REF} - V_{out} - V_{off} < 0$, that is, when $V_{REF} - V_{off} < V_{out} < V_{REF}$, the second term of Eq. 4 is dominant. In this situation, no current flows through the feedback diode 218, and the output voltage $V_{out}$ from the signal generation circuit 620 is determined according to Eq. 1 set forth above.

On the other hand, when $V_{REF} - V_{out} - V_{off} > 0$, that is, when $V_{out} < V_{REF} - V_{off}$, current flows through the feedback diode 218 and becomes logarithmically compressed, as indicated by the first term in Eq. 4. When $I_{HARP}$ is sufficiently large, the second term becomes negligible, which yields an output voltage of the differential amplifier 128 according to Eq. 5 below:

$$V_{out} = V_{REF} - V_{off} - \frac{kT}{q} \ln \frac{I_{HARP}}{I_0} \quad \ldots \ldots \ldots \ldots \ldots \ldots \ldots \quad (5)$$

The resulting conversion characteristics represented by $V_{out}$ over time is shown in FIG. 11, where it can be clearly seen that linear conversion characteristics are obtained when $V_{out} > V_{REF} - V_{off}$, and logarithmic conversion characteristics are obtained when $V_{out} < V_{REF} - V_{off}$. Thus, the readout signal obtained from the pixel circuit shown in FIG. 10 varies linearly with the signal outputted from the charge multiplying photoconversion layer 502 in low light conditions, and varies logarithmically with the signal outputted from the charge multiplying photoconversion layer 502 in bright light conditions.

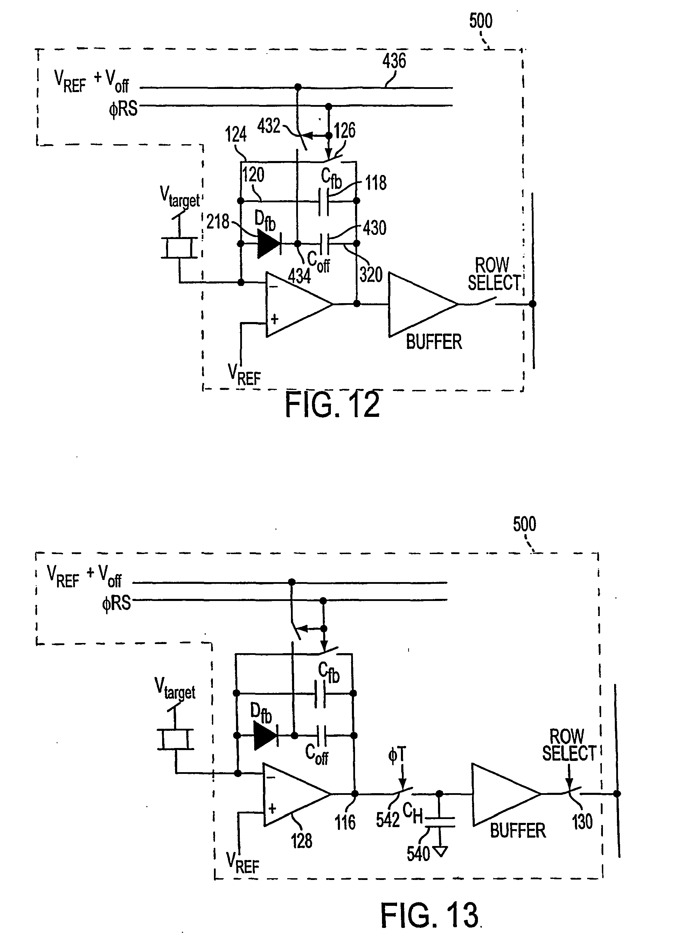

Optionally, the transition point at which the signal generation circuit 620 switches from the linear conversion mode to the logarithmic conversion mode can be made to be adjustable by enabling a user to apply a variable reverse bias potential to the feedback diode 218. This variation of the pixel circuit of FIG. 10 is illustrated in FIG. 12 and discussed below as the eighth embodiment of the present invention.

The pixel circuit shown in FIG. 12 is nearly identical to that shown in FIG. 10, except that the offset voltage source 328 in FIG. 10 is replaced with an offset capacitor 430. Again, components in FIG. 12 that are equivalent to those shown in the previous drawings are identified with the same reference numerals, and descriptions of those elements will be omitted in the explanation of this embodiment provided below.

One terminal of a switch 432 is connected to the offset capacitor 430 at a node 434 located along a feedback loop 320 between the capacitor 430 and a feedback diode 218. The other terminal of the switch 432 is connected to a voltage source 436 having a voltage $V_{REF} + V_{off}$. The voltage level of $V_{off}$ may be adjustable by a user to thereby adjust the transition point between the linear and logarithmic operation modes of the pixel circuit. The adjustable voltage $V_{off}$ is applied to the feedback diode 218 by closing the switch 432 which enables current from the voltage source 436 at the selected voltage level to flow to the capacitor 430. Even if the level of $V_{off}$ is not adjusted, the voltage level applied to the cathode of feedback diode 218 can be adjusted by controlling the length of time that the switch 432 is closed, which controls the amount of charge in, and hence the voltage across the feedback capacitor 430.

During the initialization period before the start of each integration time and before charging the offset capacitor 430, the switch 432 is closed along with reset switch 126 by a reset signal ΦRS. When the switches 126 and 432 are closed by the reset signal ΦRS, the capacitor 118 is shorted out to clear out any residual charge on the capacitors associated with the image signal most recently read out from the pixel circuit and the capacitor 430 is charged to $V_{off}$.

A ninth embodiment of the present invention is shown in FIG. 13, and is identical to the embodiment shown in FIG. 12, except that the embodiment shown in FIG. 13 further includes a circuit for performing a freeze frame shutter operation. Specifically, a freeze frame switch 542 and a hold capacitor 540 are connected in the pixel circuit between the output node 116 from the differential amplifier 128 and the row select switch 130. Freeze frame switch 542 is controlled by a transfer signal ΦT that closes the freeze frame switch 542 to enable the image signal to flow to and be stored in the hold capacitor 540. When the freeze frame switch is opened, no further charge can accumulate in the hold capacitor 540.

After charging the hold capacitor 540 with the image signal, the charge is held in the hold capacitor to enable the image signal for that pixel to be read out by closing the row select switch 130 for each readout operation. For example, when an image is captured by an entire image sensor pixel array, the image sensor can be operated in freeze frame mode in which the image signal for each pixel is frozen so that the image data from all the pixels in the array can be read out row by row. Thus, the freeze frame switch 542 is closed and then opened by operation of the transfer signal ΦT to all of the pixels in the image sensor array at the same time, whereupon the row select signal is applied to the image sensor array row by row to read out the pixel image signals.

In the embodiments shown in FIGS. 9, 10, 12 and 13 described above, feedback diode 218 may be implemented by use of the sub-threshold characteristics of a MOS transistor. It is readily understood by one of ordinary skill in the art that a MOS transistor has four operational modes depending on bias conditions: 1) when no bias is applied to the gate, the transistor is off and no current flows from the drain; 2) the transistor is in a subthreshold region when the gate voltage $V_G$ is less than a predetermined threshold voltage $V_T$, wherein the current flowing from the drain is $I_D = I_0 \cdot \exp\{q(V_G - V_T)/kT\}$; 3) the transistor is in a saturation region when $V_G - V_T < V_D$ (drain voltage), wherein the current flowing from the drain is $I_D = (\beta/2) \cdot (V_G - V_T)^2$; and 4) the transistor is in a linear region when $V_G - V_T > V_D$, wherein the current flowing from the drain is

$$I_D = \beta \cdot (V_G - V_T - V_D/2) \cdot V_D.$$

In each of the fifth through ninth embodiments of the invention as shown in FIGS. 8-13, there is no storage element connected between the bottom plate of the charge multiplying photoconversion layer and the output control circuit as is the case in the first through fourth embodiments of the invention as shown in FIGS. 4-7. Thus, in the embodiments of FIGS. 8-13, the bottom plate of the charge multiplying photoconversion layer is connected directly to the input node 122 of the respective output control circuit 500.

An additional aspect of the invention provides a pixel structure having both an output circuit 500 for maintaining a constant voltage across the charge multiplying photoconversion layer and a protection circuit 520 for dissipating excess voltage over a predetermined threshold being outputted from the charge multiplying photoconversion layer into the output control circuit 500. Here, the bottom plate of the charge multiplying photoconversion layer is connected to both the negative input of the differential amplifier 128 in the output circuit 500 and the input to the protection circuit 520.

A tenth embodiment of a pixel structure in accordance with this aspect of the invention is nearly identical to the fifth embodiment pixel structure shown in FIG. 8, but further includes a protection circuit connected to the node 122 in the output control circuit 500. As with the protection circuits described above, the protection circuit in the tenth embodiment may be constructed as a diode such as the protection diode 112 shown and described above with reference to FIG. 4, an n-MOS transistor such as the n-MOS transistor 302 shown and described above with reference to FIG. 6, a resistor and a diode such as the resistor 402 and protection diode 412 shown and described above with reference to FIG. 7, or a resistor and an n-MOS transistor as disclosed above.

An eleventh embodiment of a pixel structure in accordance with this aspect of the invention is nearly identical to the sixth embodiment pixel structure shown in FIG. 9, and further includes a protection circuit connected to the node 122 in the output control circuit 500. As with the protection circuits described above, the protection circuit in the eleventh embodiment may be constructed as a diode such as the protection diode 112 shown and described above with reference to FIG. 4, an n-MOS transistor such as the n-MOS transistor 302 shown and described above with reference to FIG. 6, a resistor and a diode such as the resistor 402 and protection diode 412 shown and described above with reference to FIG. 7, or a resistor and an n-MOS transistor as disclosed above.

A twelfth embodiment of a pixel structure in accordance with this aspect of the invention is nearly identical to the seventh embodiment pixel structure shown in FIG. 10, and further includes a protection circuit connected to the node 122 in the output control circuit 500. As with the protection circuits described above, the protection circuit in the twelfth embodiment may be constructed as a diode such as the protection diode 112 shown and described above with reference to FIG. 4, an n-MOS transistor such as the n-MOS transistor 302 shown and described above with reference to FIG. 6, a resistor and a diode such as the resistor 402 and protection diode 412 shown and described above with reference to FIG. 7, or a resistor and an n-MOS transistor as disclosed above.

A thirteenth embodiment of a pixel structure in accordance with this aspect of the invention is nearly identical to the eighth embodiment pixel structure shown in FIG. 12, and further includes a protection circuit connected to the negative input to the differential amplifier in the output control circuit 500. As with the protection circuits described above, the protection circuit in the thirteenth embodiment may be constructed as a diode such as the protection diode 112 shown and described above with reference to FIG. 4, an n-MOS transistor such as the n-MOS transistor 302 shown and described above with reference to FIG. 6, a resistor and a diode such as the resistor 402 and protection diode 412 shown and described above with reference to FIG. 7, or a resistor and an n-MOS transistor as disclosed above.

A fourteenth embodiment of a pixel structure in accordance with this aspect of the invention is nearly identical to the ninth embodiment pixel structure shown in FIG. 13, and further includes a protection circuit connected to the negative input to the differential amplifier 128 in the output control circuit 500. As with the protection circuits described above, the protection circuit in the fourteenth embodiment may be constructed as a diode such as the protection diode 112 shown and described above with reference to FIG. 4, an n-MOS transistor such as the n-MOS transistor 302 shown and described above with reference to FIG. 6, a resistor and a diode such as the resistor 402 and protection diode 412 shown and described above with reference to FIG. 7, or a resistor and an n-MOS transistor as disclosed above. circuit does not affect the operation of the pixel since the input to the differential amplifier is fixed at $V_{REF}$. However, if a storage element is present and if the differential amplifier and the feedback loop(s) are malfunctioning, the current may then accumulate at the storage element.

In each of the embodiments described above, the charge multiplying photoconversion layer is preferably a high-gain avalanche rushing amorphous photo conductor (HARP) photoconversion layer. Alternatively, however, other photosensitive elements for detecting and performing photoconversion of a light signal and subsequently or simultaneously amplifying the resulting electrical charge may be used instead, such as a photodiode or a stacked pixel sensor structure, wherein the effective light sensitive area may be significantly increased by the stacked structure. An example of a stacked pixel sensor structure is illustrated in FIG. 3 and described in fuller detail in "A Stacked CMOS APS For Charge Particle Detection And Its Noise Performance," by I. Takayanagi et al., IEEE Workshop on Charge-Coupled Devices and Advanced Image Sensors, pp. 159-162, June 1999, the contents of which are hereby incorporated by reference.

An example of an imaging device incorporating the present invention is shown in FIG. 14. Specifically, an imaging apparatus 800 includes an image sensor 802 having a pixel array arranged according to a Bayer color filter pattern. A charge multiplying photoconversion layer such as a HARP layer is provided over each of the pixels in the array under the filter pattern. Each pixel 804 contains the protection and readout circuits in accordance with any one of the various embodiments discussed herein above.

The imaging apparatus 800 further includes a row decoder 806 includes a plurality of row select activation lines 808 corresponding in number to the number of rows in the pixel array of the image sensor 802, wherein each line is connected to each row select switch in all the pixels in a respective row of the array. Similarly, column decoder 812 includes a plurality of column lines 812, the number of which corresponds to the number of columns in the pixel array of the image sensor 802. Each column line 812 is connected to the output sides of the row select switches in all the pixels in a respective column.

To read the image data obtained by the image sensor 802, controller 824 controls the row decoder 806 to sequentially activate the row select lines, whereby the row select switches for each pixel in a selected row is activated to thereby dump the image data from each respective pixel to the respective column line. Since each pixel in a row is connected to a different column line, the image data for each pixel is then read out to the image processor by sequentially activating all the column lines through column decoder 810. Thus, after activation of each row select line, the column lines are sequentially activated to collect the image data in an orderly manner across the array.

Upon reading the image data out of the pixel array, the data is passed through a number of processing circuits which, in linear order, generally include a sample and hold circuit 814, an amplifier 816, an analog to digital converter 818, an image processor 820, and an output device 822.

Without being limiting, such the imaging apparatus 800 could be part of a computer system, camera system, scanner, machine vision system, vehicle navigation system, video telephone, surveillance system, auto focus system, star tracker system, motion detection system, image stabilization system and other systems requiring an imager.

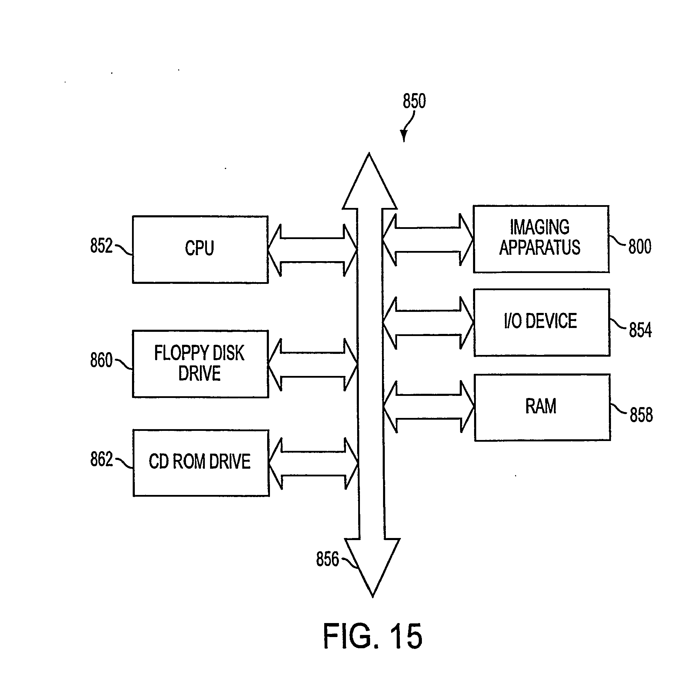

The imaging apparatus 800 may also be connected to a processor system 850, as shown in FIG. 15, such as a computer system. A processor system 850 generally comprises a central processing unit (CPU) 852 that communicates with an input/output (I/O) device 854 over a bus 856. The imaging apparatus 800 communicates with the system over bus 856 or a ported connection. The processor system 800 also includes random access memory (RAM) 858, and, in the case of a computer system, may include peripheral devices such as a floppy disk drive 860 and a compact disc (CD) ROM drive 862 which also communicate with CPU 852 over the bus 856.

Although the present invention has been described in relation to particular embodiments thereof, many other variations and modifications and other uses will become apparent to those skilled in the art. Therefore, the present invention is to be limited not by the specific disclosure herein, but only by the appended claims.

**Claims**

1.   An image sensor pixel among an array of pixels in an image sensor, comprising:

a charge multiplying photo-conversion element (102); and
a charge storage element (510) electrically connected to the charge multiplying photoconversion element (102) at a first node (104), and
a protection circuit (520) electrically **characterised in that** it is connected to the charge storage element (510) at the first node (104) and to a reference potential (Vdd) at a second node for limiting a voltage which accumulates at the charge storage element (510) to the reference potential.

2.   The image sensor pixel according to claim 1, wherein the charge multiplying photoconversion element (102) is a high gain avalanche rushing amorphous photoconductor photoconversion layer.

3.   The image sensor pixel according to claim 1, wherein the charge multiplying photoconversion element (102) is a stacked pixel structure.

4.   The image sensor pixel according to claim 1, wherein the storage element (510) is a junction photodiode (106), the cathode of which is connected to the charge multiplying photoconversion element.

5.   The image sensor pixel according to claim 1, wherein the storage element (510) is a capacitor (202).

6.   The image sensor pixel according to claim 1, wherein the protection circuit (520) includes a protection diode (112) electrically connected to the storage element (510) at the anode thereof and connected to the reference potential (Vdd) at the cathode thereof, whereby voltage accumulating at the storage element (510) in excess of the reference potential (Vdd) is transferred away from the storage element (510) through the protection diode (112).

7.   The image sensor pixel according to claim 6, wherein the protection circuit (520) further comprises a resistor (402) electrically connected between the charge multiplying photo-conversion element (102) and the storage element (510).

8. The image sensor pixel according to claim 1, wherein the protection circuit (520) includes an n-MOS transistor (302) having a drain and a gate both electrically connected to the storage element (510), and a source electrically connected to the reference potential (Vdd), whereby voltage accumulating at the storage element (510) in excess of the reference potential (Vdd) is transferred away from the storage element (510) through the n-MOS transistor (302).

9. The image sensor pixel according to claim 8, wherein the protection circuit (520) further comprises a resistor (420) electrically connected between the charge multiplying photo-conversion element (102) and the storage element (510).

10. The image sensor pixel according to claim 1, further comprising an output circuit (500) connected to the charge storage element (510) and to the protection circuit (520).

11. The image sensor pixel according to claim 10, wherein the output circuit (500) includes a row select transistor (108) which reads out the charge stored at the charge storage element (510).

12. An image sensor comprising:

a charge multiplying photoconversion element (502); and
an image sensor pixel array having a plurality of pixels, wherein each pixel comprises:

an output circuit (500) connected to the charge multiplying photoconversion element **characterised in that** the output control circuit is configured to maintain the potential across the charge multiplying photoconversion element at a predetermined voltage level.

13. A method for obtaining an image signal, comprising:

detecting a light signal in an image sensor;
photoconverting the light signal into an electrical signal in a photosensitive element (102) in the image sensor;
amplifying the electrical signal in the photosensitive element (102);
transferring the electrical signal to a storage element (510) at a first node (104);
accumulating charge from the electrical signal at the storage element (510); and
limiting the voltage at the storage element (510) to a reference potential (Vdd) using a protection circuit (520) connected to the photosensitive element (102) and the storage element (510) at the first node (104) and to the reference potential (Vdd) at a second node.

14. The method according to claim 13, wherein limiting the voltage includes transferring charge away from the storage element (510) when the voltage resulting from the accumulated charge exceeds the reference potential.

15. The method according to claim 14, wherein limiting the voltage further includes lowering the voltage of the electrical signal prior to the charge accumulating at the storage element (510).

16. The method according to claim 13, further comprising reading out the charge accumulated at the storage element (510).

17. A method for obtaining an image signal, comprising:

detecting a light signal in an image sensor;
photoconverting the light signal into an electrical signal with a charge multiplying photosensitive element (502) of the image sensor;
amplifying the electrical signal in the charge multiplying photosensitive element (502); sand
maintaining the potential across the photosensitive element (502) to be constant at a predetermined voltage level.

18. The method according to claim 17, further comprising performing a linear conversion of the electrical signal outputted from the photosensitive element (502) over the entire operating range of the photosensitive element (502).

19. The method according to claim 17, further comprising logarithmically compressing the electrical signal outputted from the photosensitive element (502) over the entire operating range of the photosensitive element (502).

20. The method according to claim 17, further comprising performing a linear conversion of the electrical signal outputted from the photosensitive element (502) when the outputted electrical signal is within a first range up to a predetermined threshold level, and logarithmically compressing the electrical signal when the outputted electrical signal is within a second range above the threshold level.

21. The method according to claim 20, further comprising adjusting the threshold level at which the output control circuit switches from performing linear conversion of the electrical signal to logarithmic compression of the electrical signal.

22. The method according to claim 17, further comprising performing a freeze frame operation on the electrical signal obtained by the charge multiplying photosensitive element (502).

23. The method according to claim 17, wherein maintaining a constant potential across the photosensitive element (502) comprises limiting the voltage of the electrical signal outputted from the charge multiplying photosensitive element (502) to the predetermined voltage level.

24. The method according to claim 23, wherein limiting the voltage includes transferring away a portion of the electrical signal which exceeds the predetermined voltage level.

25. The method according to claim 24, wherein limiting the voltage further includes lowering the voltage of the electrical signal prior to transferring away the portion of the signal which exceeds the predetermined voltage level.

26. An image processing apparatus comprising:

   an image sensor for detecting an image and outputting image signals corresponding to the detected image; and
   an image processor for processing the image signals outputted from the image sensor, wherein the image sensor includes the image sensor pixel of claim 1.

27. A processing system, comprising:

   a processor for receiving and processing image data; and
   an image data generator for supplying image data to the processor, the image data generator comprising
   an image sensor for detecting light and outputting an image signal,
   an image processor for processing the image signal, and
   a controller for controlling the image sensor and the image processor, wherein the image sensor includes the image sensor pixel of claim 1.

28. An image processing apparatus comprising:

   the image sensor of claim 12 for detecting an image and outputting image signals corresponding to the detected image; and
   an image processor for processing the image signals outputted from the image sensor,

   wherein the charge multiplying photoconversion element has an input side for detecting a light signal and an output side for outputting the detected light signal as an electrical signal.

29. The image processing apparatus of claim 28, wherein each pixel further comprises a protection circuit for limiting the voltage level at the output side of the charge multiplying photoconversion element at a predetermined voltage level.

30. A processing system, comprising:

   a processor for receiving and processing image data; and
   an image data generator for supplying image data to the processor, the image data generator comprising:

      the image sensor of claim 12 for obtaining an image and outputting an image signal,
      an image processor for processing the image signal, and

a controller for controlling the image sensor and the image processor,

wherein the charge multiplying photo-conversion element has an input side for detecting a light signal and an output side for outputting the detected light signal as an electrical signal.

31. The processing system of claim 30, wherein each pixel further comprises a protection circuit for limiting the voltage level at the output side of the charge multiplying photoconversion element at a predetermined voltage level.

**Patentansprüche**

1. Bildsensorpixel in einem Pixelarray in einem Bildsensor, umfassend:

ein Ladung vervielfachendes Photoumwandlungselement (102); und
ein Ladungsspeichexuugselement (510), das an das Ladung vervielfachende Photoumwandlungselement (102) an einem ersten Knoten (104) elektrisch angeschaltet ist, und
eine Schutzschaltung (520), **dadurch gekennzeichnet, dass** sie an das Ladungsspeicherungselement (510) am ersten Knoten (104) und an ein Referenzpotential (Vdd) an einem zweiten Knoten elektrisch angeschaltet ist, um eine Spannung zu beschränken, die am Ladungsspeicherungselement (510) zum Referenzpotential akkumuliert.

2. Bildsensorpixel nach Anspruch 1, worin das Ladung vervielfachende Photoumwandlungselement (102) eine HARP (High-Gain Avalanche Rushing Amorphous Photoconductor)-Photoumwandlungsschicht ist.

3. Bildsensorpixel nach Anspruch 1, worin das Ladung vervielfachende Photoumwandlungselement (102) eine gestapelte Pixelstruktur ist.

4. Bildsensorpixel nach Anspruch 1, worin das Speicherungselement (510) eine Übergangs-Photodiode (106) ist, deren Kathode an das Ladung vervielfachende Photoumwandlungselement angeschaltet ist.

5. Bildsensorpixel nach Anspruch 1, worin das Speicherungselement (510) ein Kondensator (202) ist.

6. Bildsensorpixel nach Anspruch 1, worin die Schutzschaltung (520) eine Schutzdiode (112) enthält, die an ihrer Anode an das Spcicherungselement (510) elektrisch angeschaltet ist und an ihrer Kathode an das Referenzpotential (Vdd) angeschaltet ist, wodurch am Speicherungselement (510) akkumulierende Spannung, die das Referenzpotential (Vdd) übersteigt, durch die Schutzdiode (112) vom Speicherungselement (510) weggeleitet wird.

7. Bildsensorpixel nach Anspruch 6, worin die Schutzschaltung (520) außerdem einen Widerstand (402) umfasst, der zwischen dem Ladung vervielfachenden Photoumwandlungselement (102) und dem Speichemngselement (510) elektrisch angeschaltet ist.

8. Bildsensorpixel nach Anspruch 1, worin die Schutzschaltung (520) einen n-MOS-Transistor (302) enthält, der einen Drain und ein Gate hat, die beide an das Speicherungselement (510) elektrisch angeschaltet sind, und eine an das Referenzpotential (Vdd) elektrisch angeschaltete Quelle, wodurch am Speicherungselement (510) akkumulierende Spannung, die das Referenzpotential (Vdd) übersteigt, durch den n-MOS-Transistor (302) vom Speicherungselement (510) weggeleitet wird.

9. Bildsensorpixel nach Anspruch 8, worin die Schutzschaltung (520) außerdem einen Widerstand (420) umfasst, der zwischen dem Ladung vervielfachenden Photoumwandlungselement (102) und dem Speicherungselement (510) elektrisch angeschaltet ist.

10. Bildsensorpixel nach Anspruch 1, außerdern eine Ausgangsschaltung (500) umfassend, die an das Ladunssspeichemngselement (510) und die Schutzschaltung (520) angeschaltet ist.

11. Bildsensorpixel nach Anspruch 10, worin die Ausgangsschaltung (500) einen Zeilenauswahltransistor (108) enthält, der die im Ladungsspeicherungselement (510) gespeicherte Ladung ausliest.

12. Bildsensor, umfassend:

ein Ladung vervielfachendes Photoumwandlungselement (502); und
ein Bildsensor-Pixelarray mit einer Vielzahl von Pixeln, worin jedes Pixel umfasst:

eine Ausgangsschaltung (500), die an das Ladung vervielfachende Photoumwandlungselement angeschaltet ist, **dadurch gekennzeichnet, dass** die Ausgangssteuerungsschaltung dazu konfiguriert ist, das Potential am Ladung vervielfachenden Photoumwandlungselement auf einem vorbestimmten Spannungspegel zu halten.

13. Verfahren zum Erhalten eines Bildsignals, umfassend:

Detektieren eines Lichtsignals in einem Bildsensor;
Photoumwandlung des Lichtsignals in ein elektrisches Signal in einem photosensitiven Element (102) im Bildsensor;
Verstärken des elektrischen Signals im photosensitiven Element (102);
Übertragen des elektrischen Signals an ein Speicherungselement (510) an einem ersten Knoten (104);
Akkumulieren von Ladung vom elektrischen Signal am Speicherungselement (510); und
Beschränken der Spannung am Speicherungselement (510) auf ein Referenzpotential (Vdd) unter Verwendung einer Schutzschaltung (520), die an das photosensitive Element (102) und das Speicherungselement (510) am ersten Knoten (104) und an das Referenzpotential (Vdd) an einem zweiten Knoten angeschaltet ist.

14. Verfahren nach Anspruch 13, worin das Beschränken der Spannung das Wegleiten der Ladung vom Speicherungselement (510) enthält, wenn die aus der akkumulierten Ladung resultierende Spannung das Referenzpotential übersteigt.

15. Verfahren nach Anspruch 14, worin das Beschränken der Spannung außerdem das Reduzieren der Spannung des elektrischen Signals enthält, bevor die Ladung am Speichezungselement (510) akkumuliert.

16. Verfahren nach Anspruch 13, außerdem umfassend, dass die am Speicherungselement (510) akkumuliert Ladung ausgelesen wird.

17. Verfahren zum Erhalten eines Bildsignals, umfassend:

Detektieren eines Lichtsignals in einem Bildsensor;
Photoumwandlung des Lichtsignals in ein elektrisches Signal mit einem Ladung vervielfachenden Photoumwandlungselement (502) des Bildsensors;
Verstärken des elektrischen Signals im Ladung vervielfachenden Photoumwandlungselement (502); und
Konstanthalten des Potentials am photosensitiven Element (502) auf einem vorbestimmten Spannungspegel.

18. Verfahren nach Anspruch 17, außerdem das Ausführen einer linearen Umwandlung des elektrischen Signals umfassend, das vom photosensitiven Element (502) über den gesamten Betriebsbereich des photosensitiven Elements (502) ausgegeben wird.

19. Verfahren nach Anspruch 17, außerdem das logarithmische Komprimieren des elektrischen Signals umfassend, das vom photosensitiven Element (502) über den gesamten Betriebsbereich des photosensitiven Elements (502) ausgegeben wird.

20. Verfahren nach Anspruch 17, außerdem das Ausführen einer linearen Umwandlung des elektrischen Signals umfassend, das vom photosensitiven Element (502) ausgegeben wird, wenn das ausgegebene elektrische Signal innerhalb eines ersten Bereichs bis zu einem vorbestimmten Schwellenpegel liegt, und das logarithmische Komprimieren des elektrischen Signals umfassend, wenn das ausgegebene elektrische Signal innerhalb eines zweiten Bereichs über dem Schwellenpegel liegt.

21. Verfahren nach Anspruch 20, außerdem das Anpassen des Schwellenpegels umfassend, an dem die Ausgangssteueruugsschaltung vom Ausführen linearer Umwandlung des elektrischen Signals auf logarithmische Komprimierung des elektrischen Signals umschaltet.

22. Verfahren nach Anspruch 17, außerdem das Ausführen einer Bildstillstandsoperation am elektrischen Signal umfassend, das durch das Ladung vervielfachende Photoumwandlungselement (502) erhalten wird.

**23.** Verfahren nach Anspruch 17, worin das Halten eines konstanten Potentials am photosensitiven Element (502) umfasst, dass die Spannung des elektrischen Signals, das vom Ladung vervielfachenden Photoumwandlungselement (502) ausgegeben wird, auf den vorbestimmten Spannungspegel beschränkt wird.

**24.** Verfahren nach Anspruch 23, worin das Beschränken der Spannung umfasst, dass ein Teil des elektrischen Signals, der den vorbestimmten Spannungspegel überschreitet, weggeleitet wird.

**25.** Verfahren nach Anspruch 24, worin das Beschränken der Spannung außerdem umfasst, dass die Spannung des elektrischen Signals reduziert wird, bevor der Teil des Signals weggeleitet wird, der den vorbestimmten Spannungspegel überschreitet,

**26.** Bildverarbeitungsvorrichtung, umfassend:

einen Bildsensor zum Detektieren eines Bilds und Ausgeben von Bildsignalen, die dem detektierten Bild entsprechen; und
einen Bildprozessor zum Verarbeiten von Bildsignalen, die vom Bildsensor ausgegeben werden,

worin der Bildsensor das Bildsensorpixel von Anspruch 1 enthält.

**27.** Verarbeitungssystem, umfassend:

einen Prozessor zum Empfangen und Verarbeiten von Bilddaten; und
einen Bilddatengenerator zum Bereitstellen von Bilddaten an den Prozessor, wobei der Bilddatengenerator umfasst:

einen Bildsensor zum Detektieren von Licht und Ausgeben eines Bildsignals,
einen Bildprozessor zum Verarbeiten des Bildsignals, und
einen Controller zum Steuern des Bildsensors und des Bildprozessors, worin der Bildsensor das Bildsensorpixel von Anspruch 1 enthält.

**28.** Bildverarbeitungsvorrichtung, umfassend:

den Bildsensor von Anspruch 12 zum Detektieren eines Bilds und Ausgeben von Bildsignalen, die dem detektierten Bild entsprechen; und
einen Bildprozessor zum Verarbeiten der Bildsignale, die vom Bildsensor ausgegeben werden,

worin das Ladung vervielfachende Photoumwandlungselement eine Eingangsseite zum Detektieren eines Lichtsignals hat und cinc Ausgangsseite zum Ausgeben des detektierten Lichtsignals als ein elektrisches Signal.

**29.** Bildverarbeitungsvorrichtung von Anspruch 28, worin jedes Pixel außerdem eine Schutzschaltung zum Beschränken des Spannungspegels an der Ausgangsseite des Ladung vervielfachenden Photoumwandlungselements auf einen vorbestimmten Spannungspegel umfasst.

**30.** Verarbeitungssystem, umfassend:

einen Prozessor zum Empfangen und Verarbeiten von Bilddaten; und
einen Bilddatengenerator zum Bereitstellen von Bilddaten an den Prozessor, wobei der Bilddatengenerator umfasst;
den Bildsensor von Anspruch 12 zum Erhalten eines Bilds und Ausgeben eines Bildsignals,
einen Bildprozessor zum Verarbeiten des Bildsignals, und
einen Controller zum Steuern des Bildsensors und des Bildprozessors,

worin das Ladung vervielfachende Photoumwandlungselement eine Eingangsseite zum Detektieren eines Lichtsignals hat und eine Ausgangsseite zum Ausgeben des detektierten Lichtsignals als ein elektrisches Signal.

**31.** Verarbeitungssystem von Anspruch 30, worin jedes Pixel außerdem eine Schutzschaltung zum Beschränken des Spannungspegels an der Ausgangsseite des Ladung vervielfachenden Photoumwandlungselements auf einen vorbestimmten Spannungspegel umfasst.

**Revendications**

1. Pixel de capteur d'image parmi un ensemble de pixels dans un capteur d'image, comprenant ;

   un élément de photoconversion multiplicateur de charge (102) ; et
   un élément de stockage de charge (510) connecté électriquement à l'élément de photoconversion multiplicateur de charge (102) au niveau d'un premier noeud (104), et
   un circuit de protection (520) **caractérisé en ce qu'**il est connecté électriquement à l'élément de stockage de charge (510) au niveau du premier noeud (104) et à un potentiel de référence (Vdd) au niveau d'un deuxième noeud pour limiter une tension qui se développe au niveau de l'élément de stockage de charge (510) au potentiel de référence.

2. Pixel de capteur d'image selon la revendication 1, dans lequel l'élément de photoconversion multiplicateur de charge (102) est une couche de photoconversion HARP (High gain Avalanche Rushing amorphous Photoconductor).

3. Pixel de capteur d'image selon la revendication 1, dans lequel l'élément de photoconversion multiplicateur de charge (102) est une structure de pixels empilés.

4. Pixel de capteur d'image selon la revendication 1, dans lequel l'élément de stockage (510) est une photodiode à jonction (106), dont la cathode est connectée à l'élément de photo-conversion multiplicateur de charge.

5. Pixel de capteur d'image selon la revendication 1, dans lequel l'élément de stockage (510) est un condensateur (202).

6. Pixel de capteur d'image selon la revendication 1, dans lequel le circuit de protection (520) comprend une diode de protection (112) connectée électriquement à l'élément de stockage (510) au niveau de son anode et connectée au potentiel de référence (Vdd) au niveau de sa cathode, moyennant quoi une tension se développant au niveau de l'élément de stockage (510) au-delà du potentiel de référence (Vdd) est transférée hors de l'élément de stockage (510) par l'intermédiaire de la diode de protection (112).

7. Pixel de capteur d'image selon la revendication 6, dans lequel le circuit de protection (520) comprend en outre une résistance (402) connectée électriquement entre l'élément de photoconversion multiplicateur de charge (102) et l'élément de stockage (510).

8. Pixel de capteur d'image selon la revendication 1, dans lequel le circuit de protection (520) comprend un transistor n-MOS (302) comportant un drain et une grille, tous deux connectés électriquement à l'élément de stockage (510), et une source connectée électriquement au potentiel de référence (Vdd), moyennant quoi une tension se développant au niveau de l'élément de stockage (510) au-delà du potentiel de référence (Vdd) est transférée hors de l'élément de stockage (510) par l'intermédiaire du transistor n-MOS (302).

9. Pixel de capteur d'image selon la revendication 8, dans lequel le circuit de protection (520) comprend en outre une résistance (420) connectée électriquement entre l'élément de photoconversion multiplicateur de charge (102) et l'élément de stockage (510).

10. Pixel de capteur d'image selon la revendication 1, comprenant en outre un circuit de sortie (500) connecté à l'élément de stockage de charge (510) et au circuit de protection (520).

11. Pixel de capteur d'image selon la revendication 10, dans lequel le circuit de sortie (500) comprend un transistor de sélection de rangée (108) qui extrait la charge stockée au niveau de l'élément de stockage de charge (510).

12. Capteur d'image comprenant

    un élément de photoconversion multiplicateur de charge (502) ; et
    un ensemble de pixels de capteur d'image comportant une pluralité de pixels, dans lequel chaque pixel comprend :

    un circuit de sortie (500) connecté à l'élément de photoconversion multiplicateur de charge, **caractérisé en ce que** le circuit de commande de sortie est configuré pour maintenir le potentiel aux bornes de élément de photoconversion multiplicateur de charge à un niveau de tension prédéterminé.

**13.** Procédé pour obtenir un signal d'image, comprenant les étapes consistant à :

détecter un signal de lumière dans un capteur d'image
convertir photoélectriquement le signal de lumière en un signal électrique dans un élément photosensible (102) du capteur d'image ;
amplifier le signal électrique dans l'élément photosensible (102) ;
transférer le signal électrique à un élément de stockage (510) au niveau d'un premier noeud (104) ;
accumuler une charge provenant du signal électrique au niveau de l'élément de stockage (510) ; et
limiter la tension au niveau de l'élément de stockage (510) à un potentiel de référence (Vdd) en utilisant un circuit de protection (520) connecté à l'élément photosensible (102) et à l'élément de stockage (510) au niveau du premier noeud (104) et au potentiel de référence (Vdd) au niveau d'un deuxième noeud.

**14.** Procédé selon la revendication 13, dans lequel l'étape consistant à limiter la tension comprend le transfert d'une charge hors de l'élément de stockage (510) lorsque la tension résultant de la charge accumulée dépasse lie potentiel de référence.

**15.** Procédé selon la revendication 14, dans lequel l'étape consistant à limiter la tension comprend en outre la diminution de la tension du signal électrique avant l'accumulation de la charge au niveau de l'élément de stockage (510).

**16.** Procédé selon la revendication 13, comprenant en outre l'étape consistant à extraire la charge accumulée au niveau de l'élément de stockage (510).

**17.** Procédé pour obtenir un signal d'image, comprenant les étapes consistant à :

détecter un signal de lumière dans un capteur d'image ;
convertir photoélectriquement le signal de lumière en un signal électrique par un élément photosensible multiplicateur de charge (502) du capteur d'image ;
amplifier le signal électrique dans élément photosensible multiplicateur de charge (502) ; et
maintenir le potentiel aux bornes de l'élément photosensible (502) pour qu'il soit constant à un niveau de tension prédéterminé.

**18.** Procédé selon la revendication 17, comprenant en outre l'étape consistant à appliquer une conversion linéaire au signal électrique délivré par l'élément photosensible (502) dans la plage de fonctionnement entière de l'élément photosensible (502).

**19.** Procédé selon la revendication 17, comprenant en outre l'étape consistant à compresser logarithmiquement le signal électrique délivré par l'élément photosensible (502) dans la plage de fonctionnement entière de l'élément photosensible (502).

**20.** Procédé selon la revendication 17, comprenant en outre l'étape consistant à appliquer une conversion linéaire au signal électrique délivré par l'élément photosensible (502) lorsque le signal électrique délivré est dans une première plage jusqu'à un niveau de seuil prédéterminée et compresser logarithmiquement le signal électrique lorsque le signal électrique délivré est dans une deuxième plage au-dessus du niveau de seuil.

**21.** Procédé selon la revendication 20, comprenant en outre l'étape consistant à ajuster le niveau de seuil auquel le circuit de commande de sortie passe de l'application d'une conversion linéaire du signal électrique à une compression logarithmique du signal électrique.

**22.** Procédé selon la revendication 17, comprenant en outre l'application d'une opération consistant à figer l'image au signal électrique obtenu par l'élément photosensible multiplicateur de charge (502).

**23.** Procédé selon la revendication 17, dans lequel l'étape consistant à maintenir un potentiel constant aux bornes de l'élément photosensible (502) comprend la limitation de la tension du signal électrique délivré par élément photosensible multiplicateur de charge (502) au niveau de tension prédéterminé.

**24.** Procédé selon la revendication 23, dans lequel l'étape consistant à limiter la tension comprend le transfert d'une partie du signal électrique qui dépasse le niveau de tension prédéterminé.

**25.** Procédé selon la revendication 24, dans lequel l'étape consistant à limiter la tension comprend en outre la diminution de la tension du signal électrique avant le transfert de la partie du signal qui dépasse le niveau de tension prédéterminé.

**26.** Dispositif de traitement d'image comprenant :

un capteur d'image pour détecter une image et délivrer des signaux d'image correspondant à l'image détectée ; et
un processeur d'image pour traiter les signaux d'image délivrés par le capteur d'image, dans lequel le capteur d'image comprend le pixel de capteur d'image selon la revendication 1.

**27.** Système de traitement, comprenant :

un processeur pour recevoir et traiter des données d'image ; et
un générateur de données d'image pour délivrer les données d'image au processeur, le générateur de données d'image comprenant :

un capteur d'image pour détecter une lumière et délivrer un signal d'image,
un processeur d'image pour traiter le signal d'image, et
un contrôleur pour commander le capteur d'image et le processeur d'image, dans lequel le capteur d'image comprend le pixel de capteur d'image selon la revendication 1.

**28.** Dispositif de traitement d'image comprenant :

le capteur d'image selon la revendication 12 pour détecter une image et délivrer des signaux d'image correspondant à l'image détectée ; et
un processeur d'image pour traiter les signaux d'image délivrés par le capteur d'image,

dans lequel l'élément de photoconversion multiplicateur de charge a un côté d'entrée pour détecter un signal de lumière et un côté de sortie pour délivrer le signal de lumière détecté en tant que signal électrique.

**29.** Dispositif de traitement d'image selon la revendication 28, dans lequel chaque pixel comprend en outre un circuit de protection pour limiter le niveau de tension du côté de sortie de l'élément de photoconversion multiplicateur de charge à une niveau de tension prédéterminé.

**30.** Système de traitement, comprenant :

un processeur pour recevoir et traiter des données d'image ; et et
un générateur de données d'image pour délivrer des données d'image au processeur; le générateur de données d'image comprenant:

le capteur d'image selon la revendication 12 pour obtenir une image et délivrer un signal d'image,
un processeur d'image pour traiter le signal d'image, et
un contrôleur pour commander le capteur d'image et le processeur d'image,

dans lequel élément de photoconversion multiplicateur de charge a un côté d'entrée pour détecter un signal de lumière et un côté de sortie pour délivrer le signal de lumière détecté en tant que signal électrique.

**31.** Système de traitement selon la revendication 30, dans lequel chaque pixel comprend en outre un circuit de protection pour limiter le niveau de tension du côté de sortie de l'élément de photoconversion multiplicateur de charge à un niveau de tension prédéterminé.

**FIG. 1A**
(PRIOR ART)

**FIG. 1B**
(PRIOR ART)

FIG. 2
(PRIOR ART)

FIG. 3
(PRIOR ART)

## FIG. 4

## FIG. 5

FIG. 6

FIG. 7

FIG. 8

FIG. 9

FIG. 10

OUTPUT VOLTAGE

$V_{REF}$

LINEAR REGION

$V_{REF} - V_{off}$

LOG REGION

TIME

FIG. 11

FIG. 12

FIG. 13.

FIG. 14

850

852 — CPU

FLOPPY DISK
DRIVE
860

862 — CD ROM DRIVE

IMAGING
APPARATUS ~800

I/O DEVICE ~854

RAM ~858

856

FIG. 15

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5818052 A
- US 5371392 A

- EP 1187217 A

### Non-patent literature cited in the description

- **T. WATABE et al.** CMOS Image Sensor Overlaid with a HARP Photoconversion Layer. *Program of the 1999 IEEE Workshop on Charge-Coupled Devices and Advanced Image Sensors,* 1999, 211-214
- **YAMAUCHI.** CMOS image sensor overlaid with a HARP photoconversion film. *Conference Proceedings on Optoelectronic and Microelectronic Materials and Devices,* 06 December 2000, 89-92

- **I. TAKAYANAGI et al.** A Stacked CMOS APS For Charge Particle Detection And Its Noise Performance. *IEEE Workshop on Charge-Coupled Devices and Advanced Image Sensors,* June 1999, 159-162